Europäisches Patentamt

European Patent Office

Office européen des brevets

(11) Publication number: **0 099 092
B1**

(12) **EUROPEAN PATENT SPECIFICATION**

(45) Date of publication of patent specification: **30.12.86**

(51) Int. Cl.⁴: **H 05 K 7/20**

(21) Application number: **83106755.8**

(22) Date of filing: **09.07.83**

(54) Series-parallel flow cooling apparatus.

(30) Priority: **12.07.82 JP 120841/82**

(43) Date of publication of application:
**25.01.84 Bulletin 84/04**

(45) Publication of the grant of the patent:
**30.12.86 Bulletin 86/52**

(84) Designated Contracting States:
**CH DE FR GB LI SE**

(56) References cited:

**IBM TECHNICAL DISCLOSURE BULLETIN, vol.
21, no. 6, November 1978, New York, D.T.,
FOLLETTE et al. "Controlled frontal bypass
configuration for air-cooled computer frames",
pages 2432, 2433**

**IBM TECHNICAL DISCLOSURE BULLETIN, vol.
22, no. 22, July 1979, New York, U.P. HWANG
et al. "Push-pull multi-flow system for air-
cooled modules", pages 696, 697**

(73) Proprietor: **Matsumura, Susumu
c/o The Kansai Electric Power Co., Inc., Technical
Research Center 11-20 Nakoji 3 chome
Amagasaki-shi Hyogo 661 (JP)**

(73) Proprietor: **MITSUBISHI DENKI KABUSHIKI
KAISHA
2-3, Marunouchi 2-chome Chiyoda-ku
Tokyo 100 (JP)**

(72) Inventor: **Matsumura, Susumu KANSAI
ELECTRIC POWER CO., INC.
Technical Research Center 11-20 Nakoji 3 chome
Amagasaki-shi Hyogo 661 (JP)**
Inventor: **Takahashi, Yasuhide c/o MITSUBISHI
DENKI K.K.
Itami Works, 80 Azanakano Minami Shimizu
Amagasaki-shi Hyogo (JP)**
Inventor: **Takahashi, Nobuyoshi c/o
MITSUBISHI DENKI K.K.
Itami Works 80 Azanakano Minami Shimizu
Amagasaki-shi Hyogo (JP)**
Inventor: **Nitta, Tohei c/o MITSUBISHI DENKI
K.K.
Itami Works 80 Azanakano Minami Shimizu
Amagasaki-shi Hyogo (JP)**

(74) Representative: **Eisenführ & Speiser
Martinistrasse 24
D-2800 Bremen 1 (DE)**

Courier Press, Leamington Spa, England.

## Description

Background of the invention
Field of the invention

The present invention relates to a series-parallel flow cooling apparatus, according to the first part of claim 1, utilized for semiconductors for electric power as well as thyristor valves for dc power transmission wherein semiconductors such as thyristor elements and the like are employed.

Description of the prior art

When cooling apparatuses utilized for semiconductor devices for electric power, valves for dc power transmission or the like wherein semiconductors such as thyristor elements and the like are employed are classified in accordance with cooling system, they are divided broadly into three categories, i.e., water cooling, oil cooling and air cooling systems. Among them, series flow systems or series-parallel flow system is usually utilized in case of water cooling and oil cooling, whilst parallel flow system is utilized in case of air cooling in most cases.

Meanwhile water cooling is often utilized, because cooling performance thereof is excellent. In general, however, semiconductor devices for electric power are operated at high voltages so that there is a problem in insulation, and solution for such problem is a technical question.

In case of oil cooling, there is such a disadvantage in that since semiconductors are immersed in insulating oil, the weight thereof is considerably heavy, besides such oil sticks to parts of the semiconductors and the like, even if the insulating oil has been extracted from the apparatus in case of maintenance and inspection, or the like case thereof so that such apparatus is troublesome in handling.

In case of air cooling, parallel flow system of open-air type has been often adopted. And in case of such parallel flow system, there is such an advantage that a temperature difference between a plurality of thyristor elements is small, whilst there are also such disadvantages that much cooling air flow is required so that the cooling construction therefor must be large-scale one. In addition to the above, there is a danger of causing drift, i.e., such a state where cooling air flow is not uniformly supplied to cooling fins for thyristor elements in a semiconductor device for electric power in which a great many thyristor elements are used. In such condition as mentioned above, junction temperatures of the respective thyristor elements become naturally unhomogeneous and as the result, electrical characteristics of the thyristor elements are adversely affected. Furthermore, when such junction temperature of a thyristor element increases abnormally up to around 125°C, the thyristor element is damaged. For these reasons, since it is required to previously increase cooling air flow, there is such a disadvantage that power of an auxiliary machinery, for example, power of a blower must be increased.

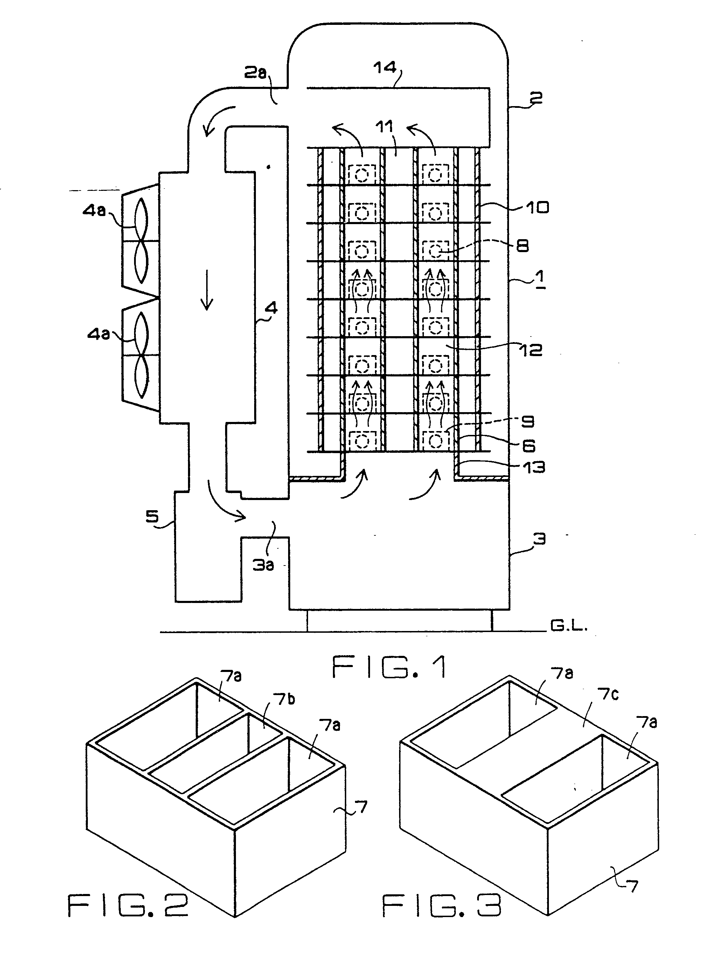

In a series flow system, as specified in the first part of claim 1, and as described in e.g. IEEE Power Engineering Soc. 1983, New York, 83 WM 170—8, pages 1—9, S. Matsumura, et al; there is proposed such a conventional apparatus as shown in Figs. 1—4 wherein reference numeral 1 designates a tank for supplying a cooling gas which consists of an upper tank 2 being provided with an exhaust port 2a for the cooling gas and a lower tank 3 being provided with a feed port 3a for the gas. A cooler 4 for dissipating heat generated in thyristor elements described hereunder outside is disposed in between the exhaust port 2a and the feed port 3a. The cooler 4 is provided with fans 4a on the side wall thereof. A blower 5 for circulating cooling gas which is placed between the lower tank 3 and the cooler 4 to connect them with each other thereby to pass the gas therethrough. Each module 6 consists of each module insulating air duct 7, each thyristor element 8 contained in such a module insulating air duct 7, and each cooling fin 9, and the module is supported by an insulating stanchion 10. The module insulating air duct 7 comprises cells 7a each containing the thyristor element 8 as well as the cooling fin 9 and a cell 7b for containing electrical parts which is placed in between these cells 7a as shown in Figs. 2 and 3. The whole bottom of the electrical part cell 7b is closed with a blind cap 7c as shown in Fig. 3 so that gas flows only through the cells 7a positioned on the opposite sides of the module insulating air duct 7. A semiconductor cooling air duct 12 is formed by piling up the modules 6 so as to allow the cells 7a to communicate with each other.

Reference numeral 13 designates an insulating air duct for introducing gas into a module 6, and which supports the modules 6 piled up and at the same time, insulates current flowing through the modules 6. Reference numeral 14 designates a blow-off air duct for conducting the gas passing through the modules 6 to the cooler 4.

Next, operation of such conventional series flow cooling apparatus as mentioned above will be described.

A cooling gas supplied from the blower 5 enters first the lower tank 3, and the cooling gas is introduced to the cells 7a of each module 6 through the insulating air duct 13. In this case, the gas passes through only the cells 7a of each module 6, i.e., the semiconductor cooling air duct 12, during this passage, the gas moves upwardly while absorbing heat produced by the thyristor elements 8 and is collected in the blow-off air duct 14. Accordingly, the cooling gas on this occasion rises in temperature by such a quantity which is determined by thermal capacity, air flow and total calorific value. The gas of such increased temperature is subjected to heat exchange by means of the open air at the time when the gas passes through the cooler 4, whereby the gas is again cooled, and then circulation of such gas is again repeated from the blower 5.

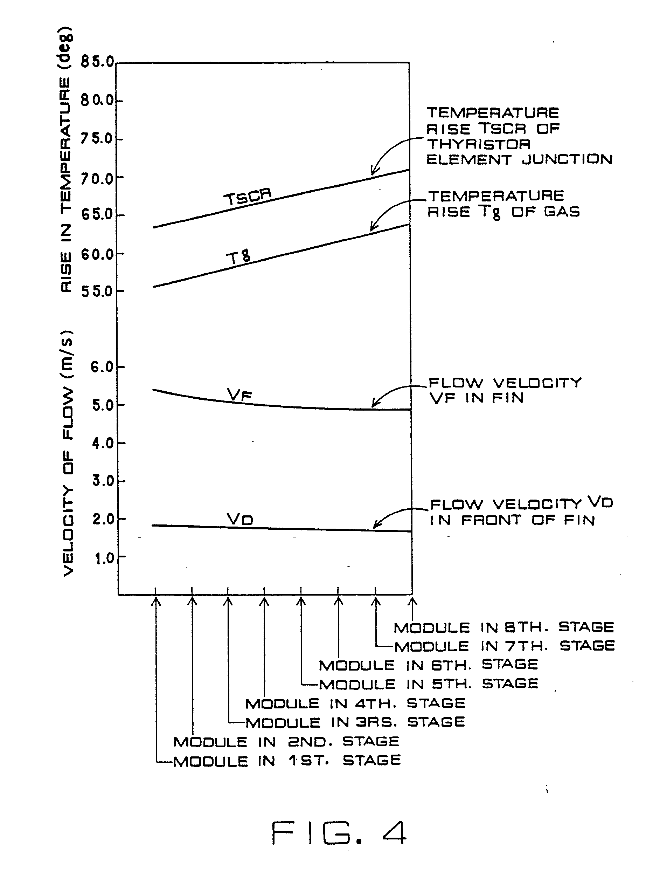

Fig. 4 is a graphical representation illustrating cooling characteristics of module portions in the course of circulation of such cooling gas wherein the modules 6 are piled up in series in eight stages to form a column, and two of such columns are disposed in parallel to each other.

In the graph, the position of stage of the respective modules 6 is plotted as abscissa and velocity of flow as well as rise in temperature as ordinates, respectively, wherein symbol $V_D$ designates flow velocity in the front of a fin, $V_F$ flow velocity in a fin, $T_g$ temperature rise of the gas, and $T_{SCR}$ temperature rise of a thyristor element junction, respectively.

As apparent from Fig. 4, in such a conventional series flow system, the flow velocity $V_D$ in the front of a fin and the flow velocity $V_F$ in a fin are substantially constant, so that temperatures rise with a constant gradient in respect of the temperature rise $T_g$ of gas and the temperature rise $T_{SCR}$ of a thyristor element junction. For example, there is a temperature difference of about 8 deg. between the temperatures of thyristor element junctions in the first and eighth modules. Accordingly, the temperatures of thyristor element junctions vary so that electrical characteristics of the thyristor elements are adversely affected.

Summary of the invention

The present invention has been made to eliminate disadvantages of such a conventional apparatus as mentioned above and an object of the invention is to provide a series-parallel flow cooling apparatus having both advantages in series and parallel flow systems and obtained by combining a construction of series flow system with that of parallel flow system wherein a by-pass air duct as specified in the characterising part of claim 1 provided with an inlet in a prescribed position is disposed in addition to a semiconductor cooling air duct, whereby temperatures of thyristor element junctions are uniformalized, its cooling air flow is minimized, and reduction for power of auxiliary machineries is intended.

Other objects and advantages of the present invention will become apparent from the description of the following preferred embodiment by referring to the accompanying drawings.

Brief description of the drawings

Fig. 1 is an elevational view showing a conventional series flow cooling apparatus;

Fig. 2 is a perspective view showing a conventional module insulating air duct;

Fig. 3 is a perspective view showing the bottom of the module insulating air duct in Fig. 2;

Fig. 4 is a graphical representation illustrating cooling characteristics of the conventional series flow cooling apparatus;

Fig. 5 is an elevational view showing an embodiment of the series-parallel flow cooling apparatus according to the present invention;

Figs. 6 and 7 are perspective views each showing the bottom of a module insulating air duct according to the present invention;

Fig. 8 is a perspective view showing a throttle plate utilized for the module insulating air duct of the invention;

Figs. 9 and 10 are perspective views each showing the module insulating air duct of the invention being provided with gas inlets;

Fig. 11 is a graphical representation illustrating cooling characteristics of the series-parallel flow cooling apparatus in accordance with the present invention; and

Fig. 12 is a graphical representation illustrating characteristic curves of a blower utilized in the apparatus of the present invention.

Description of the preferred embodiments

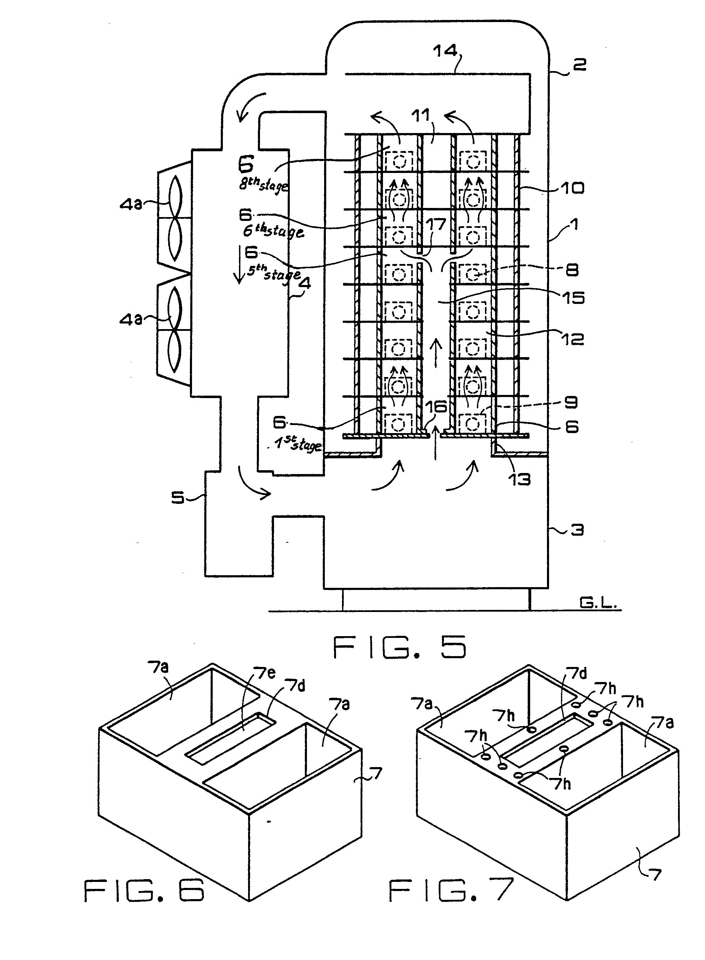

An embodiment of the present invention will be described hereinbelow by referring to Figs. 5—12 wherein the same parts with those of Figs. 1—4 are designated by the same reference numerals.

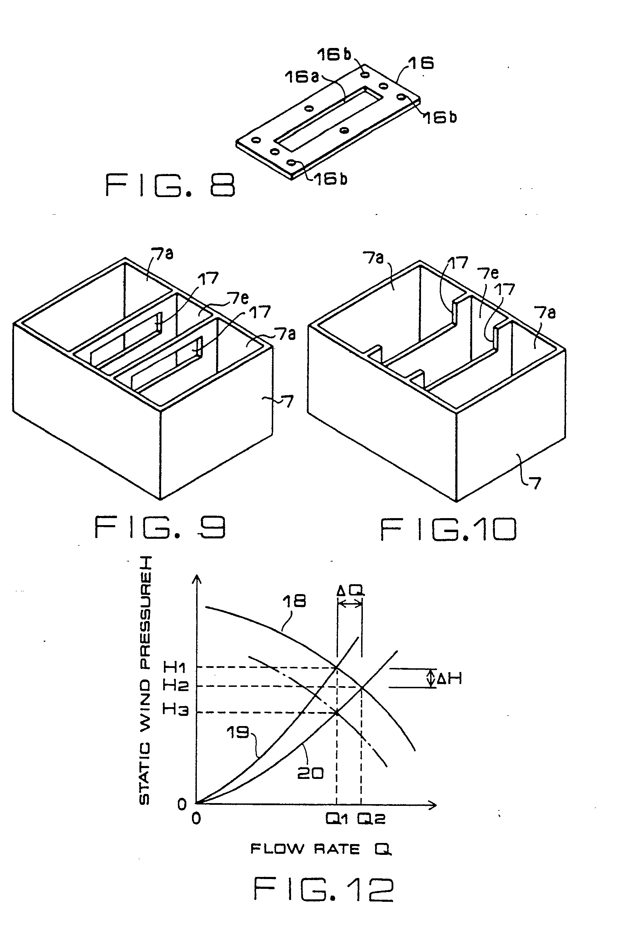

Module insulating air ducts 7 placed on from the 6th. stage to the 8th. stage in the present embodiment are identical to conventional ones, whilst module insulating air ducts placed on from the 1st. to the 5th. stages are ones each of which is formed, as shown in the perspective view of Fig. 6, in such that, for example, a rectangular opening 7d is defined on a blind cap 7c of a conventional module insulating air duct 7 in the central part thereof so that a cooling gas can circulate through cells 7a and an air duct cell 7e. Reference numeral 15 designates a by-pass air duct which is formed by piling up modules 6 so as to allow air duct cells 7d to communicate with each other, and the by-pass air duct 15 communicates with a lower tank 3. A throttle plate 16 is attached to the 1st. stage of module 6 and which regulates flow rate balance of the cooling gas. The throttle plate 16 involves an opening 16a having a shape corresponding to that of the rectangular opening 7d of the blind cap 7c as shown in, for example, Figs. 7 and 8. Circular holes 7h and 16b are bored in the blind cap 7c and the throttle plate 16 in their respective corresponding positions to each other. Then, the throttle plate 16 is attached to the blind cap 7c by means of bolts, nuts and the like through the circular holes 7h and 16b, respectively, so that area of the rectangular opening 7d is adjusted to a suitable opening area. Gas inlets 17 are defined on the side wall of the by-pass air duct 15 in a position corresponding to a prescribed position of the module 6 (the module in the 5th. stage in this embodiment) and which are for supplying a cold gas fed from the lower tank 3 to a semiconductor cooling air duct 12 corresponding to the modules 6 from the 6th. stage on through the by-pass air duct 15. The gas inlets 17 are defined on the side walls of an air duct cell 7e of a module insulating air duct 7 in a prescribed stage as shown in Figs. 9 and 10, and the gas inlets permit the central air duct cell 7e to communicate with the cells 7a positioned on the right and left sides of the air duct cell 7e.

Next, operation of the series-parallel flow cooling apparatus according to the present invention will be described hereinbelow.

The cooling gas which was supplied from the blower 5 and has been in the lower tank 3 is separated into a component which passes through the insulating air duct 13 and then flows into the semiconductor cooling air duct 12 through the cells 7a of each module 6 and the other component which flows into the by-pass air duct 15 disposed in the central part of the tank. In this case, temperature of the cooling gas passing through the semiconductor cooling air duct 12 rises with upward movement thereof, because of heat generation of the thyristor elements 9 contained in the cells 7a, whilst the cooling gas passing through the by-pass air duct 15 accompanies no rise in temperature, more specifically, this cooling gas is never heated until the gas flows into the cells 7a of the module 6 through the gas inlets 17 defined on the side wall of the module 6 in the 5th. stage in the present embodiment so that such gas described above is supplied to the semiconductor cooling air duct 12 corresponding to the modules 6 from the 6th. stage on while keeping the gas cold.

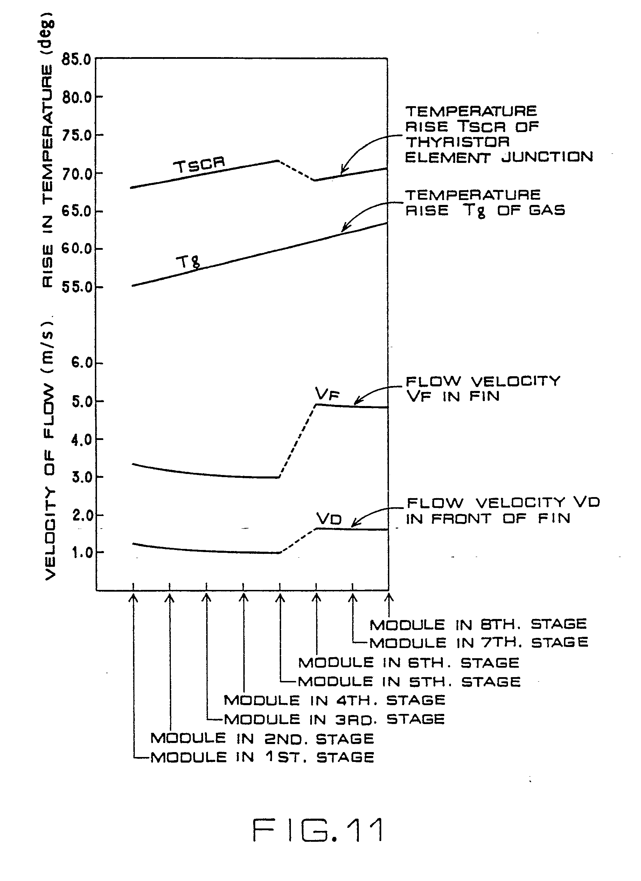

Accordingly, the cold gas supplied from the by-pass air duct 15 through the gas inlets 17 flows together with the gas heated which has passed through the semiconductor cooling air duct 12 composed of the modules 6 below the 5th. stage into the cells 7a of the modules 6 from the 6th stage on so that thermal resistance of cooling fins 9 becomes small. As the result, the junction temperature of thyristor elements decreases. Fig. 11 is a graphical representation illustrating cooling characteristics of the module part in the course of circulation of such cooling gas as mentioned above.

In the modules 6 from the 1st. stage to the 5th. stage, since flow rate of the cooling gas supplied to the cells 7a decreases by the amount of flow rate of the gas passing through the by-pass air duct 15, values of a flow velocity $V_D$ in the front of a fin and a flow velocity $V_F$ in a fin become small. Because of influence of such phenomenon as mentioned above, a temperature rise $T_{SCR}$ of a thyristor element is about 5 deg. higher than that of a conventional one. However, since cold gas is again supplied through the gas inlets 17 at the modules 6 from the 6th. stage on, flow velocity increases so that the cooling characteristics of temperature rise $T_{SCR}$ of the thyristor element junctions become similar to those of a conventional series flow system.

As is apparent from Fig. 11, the temperature rise $T_{SCR}$ of thyristor element junction indicates substantially uniform distribution of temperature over the modules 6 from the 1st. stage to the 8th. stage.

Under the circumstances, it is important to take flow rate balance between the gases passing through the modules 6 as well as the by-pass air duct 15, respectively, into consideration in case of the series-parallel flow system according to the present invention. As a means for adjusting such balance of pressure loss, it is effective to provide the aforesaid throttle plates 16 or to regulate opening area of the gas inlets 17.

Fig. 12 is a graphical representation illustrating characteristic curves which are obtained by comparing a conventional series flow system with the series-parallel flow system according to the present invention with the use of blowers having identical performance with each other wherein numeral 18 designates Q-H curve, 19 pressure loss characteristic curve of the conventional series flow system, and 20 pressure loss characteristic curve of the series-parallel flow system according to the present invention, respectively.

In case of the present series-parallel flow system, as a result of actual measurement or the like, pressure loss is smaller by $\Delta H$ than that of the conventional series flow system shown in Fig. 1 so that flow rate of the blower 5 increases by $\Delta Q$. For instance, the minimum flow rate required is represented by $Q_1$, and if only cooling gas is supplied with the flow rate $Q_1$, it is possible to previously reduce power of the blower 5 by such increment $\Delta Q$.

Namely, power in case of a conventional series flow system is given by the following equation:

$$P_1 = \frac{Q_1 H_1}{6120n} (KW).$$

On the other hand, if the minimum flow rate required is represented by $Q_1$, power in case of the present series-parallel flow system is as follows:

$$P_3 = \frac{Q_1 H_3}{6120n} (KW),$$

and as a result, reduction

$$\Delta P = \frac{Q_1 H_1}{6120n} - \frac{Q_1 H_3}{6120n} (KW)$$

is attained. In this connection, if it is not intended to particularly reduce power of the blower 5, temperature rise $T_{SCR}$ of the thyristor element junction comes to be lower by an amount corresponding to the increment $\Delta Q$ of flow rate.

As described above, a construction of series flow system is combined with that of parallel flow system, and a by-pass air duct provided with an inlet in a prescribed position is disposed in addition to a semiconductor cooling air duct for cooling semiconductors such as thyristors and the like in the series-parallel flow cooling apparatus according to the present invention. As the result, the series-parallel flow cooling apparatus of the invention has very excellent advantages such as uniformalization of temperatures of thyristor element junctions, improvement of electrical characteristics, minimization of cooling air flow, reduction of power, elevation of cooling efficiency and the like.

Although the specific case of cooling thyristor elements has been described in the above embodiment, the present invention is, of course, applicable for any types of semiconductor which must be cooled.

Furthermore, any construction can be applied to the rectangular opening of module insulating air duct and the throttle plate so far as they can effectively regulate the flow rate balance.

## Claims

1. A series-parallel flow cooling apparatus comprising a tank (1) provided with a feed port (3a) and an exhaust port (2a) for circulating a cooling gas, a plurality of modules (6) being aligned vertically in said tank (1), each of said modules (6) comprising an insulating air duct (7) which contains semiconductors (8) and cooling fins (9) placed in open cells (7a) formed in the insulating air duct (7), each of said modules (6) further comprising a central cell (7e) placed between said open cells (7a) for accommodating electrical parts (11) whereby by piling up said modules (6) air ducts (12) are formed through which said cooling gas can flow to effect cooling of said semiconductors (8) characterized in that a by-pass air duct is formed by arranging a certain number of modules (6) having open air duct central cells (7e), which by-pass air duct is formed so as to communicate with said modules (6) and communicate with said feed port (3a) for gas in said tank (1) and that a gas inlet (17) is formed in openings of the side walls of the central cell of the last module having an open air duct central cell so that the by-pass communicates with the semiconductor cooling air ducts of the remaining modules (6) in said pile, the central cells of said remaining modules being closed.

2. A series-parallel flow cooling apparatus as claimed in claim 1, characterized in that said open air duct central cells (7e) comprise an opening (7d) which is defined on a blind cap (7b) in the central part of said module (6).

3. A series-parallel flow cooling apparatus as claimed in claim 1 or 2, characterized in that the first module at the bottom of said pile comprises a throttle plate (16) having an opening of a shape corresponding to that of the opening of said open air duct central cells (7e) for defining a suitable gas flow.

## Patentansprüche

1. Serien-Parallel-Fluß-Kühlvorrichtung mit einem Behälter (1), der mit einer Zuleitungsöffnung (3a) und einer Auslaßöffnung (2a) zum Zirkulieren eines Kühlgases versehen ist, wobei mehrere Module (6) in dem Behälter (1) vertikal zueinander ausgerichtet sind, jedes der Module (6) einen isolierenden Luftkanal (7) aufweist, der Halbleiter (8) und Kühlrippen (9) enthält, die in offenen Zellen (7a) angeordnet sind, die in dem isolierenden Luftkanal (7) ausgebildet sind, wobei jedes der Module (6) weiterhin eine zentrale Zelle (7e) enthält, die zwischen den offenen Zellen (7a) zur Unterbringung elektrischer Teile (11) angeordnet ist, und wobei durch Stapeln der Module (6) Luftkanäle (12) gebildet werden, durch die das Kühlgas fließen und ein Kühlen der Halbleiter (8) bewirken kann, dadurch gekennzeichnet, daß ein Bypass-Luftkanal durch Anordnen einer bestimmten Anzahl Module (6) gebildet wird, die zentrale Zellen (7e) mit offenem Luftkanal aufweisen, wobei der Bypass-Luftkanal so ausgebildet ist, daß er mit den Modulen (6) und mit der Zuleitungsöffnung für Gas in dem Behälter (1) kommuniziert und daß ein Gaseinlaß (17) in Öffnungen der Seitenwände der zentralen Zelle des letzten Moduls mit einer einen offenen Luftkanal aufweisenden zentralen Zelle ausgebildet ist, so daß der Bypass mit den Halbleiter-Kühlluftkanälen der verbleibenden Module in dem Stapel kommuniziert, wobei die zentralen Zellen der übrigen Module geschlossen sind.

2. Serien-Parallel-Fluß-Kühlvorrichtung nach Anspruch 1, dadurch gekennzeichnet, daß die zentralen Zellen (7e) mit offenem Luftkanal eine Öffnung (7d) aufweisen, die auf einer blinden Kappe (7b) im Mittelteil des Moduls (6) ausgebildet ist.

3. Serien-Parallel-Fluß-Kühlvorrichtung nach Anspruch 1 oder 2, dadurch gekennzeichnet, daß das erste Modul am Boden des Stapels eine Drosselplatte (16) enthält, die eine Öffnung aufweist, deren Form der der Öffnung der zentralen Zellen (7e) mit offenem Luftkanal zur Bildung eines geeigneten Gasflusses entspricht.

## Revendications

1. Appareil de refroidissement à écoulement en série-parallèle, comportant une enceinte (1) munie d'un orifice d'admission (3a) et d'un orifice d'évacuation (2a) pour la circulation d'un gaz de refroidissement, plusieurs modules (6) étant alignés verticalement dans ladite enceinte (1), chacun desdits modules (6) comportant un conduit d'air d'isolation (7) qui contient des semi-conducteurs (8) et des ailettes de refroidissement (9) placées dans des cellules overtes (7a) formées dans le conduit d'air d'isolation (7), chacun desdits modules (6) comportant en outre une cellule centrale (7e) placée entre lesdites cellules overtes (7a) pour recevoir des composants électriques (11), grâce à quoi, par l'empilage desdits modules (6), sont formés des conduits d'air (12) à travers lesquels ledit gaz de refroidissement peut circuler pour réaliser le refroidissement desdits semi-conducteurs (8), caractérisé en ce qu'un conduit de dérivation d'air est formé par l'aménagement d'un certain nombre de modules (6) ayant des cellules centrales ouvertes (7e) formant conduit d'air, ledit conduit de dérivation d'air étant formé de manière à communiquer avec lesdits modules (6) et à communiquer avec ledit orifice d'admission (3a) pour le gaz dans ladite enceinte (1), et en ce qu'une admission de gaz (17) est formée dans des ouvertures des parois latérales de la cellule centrale du dernier module ayant une cellule centrale ouverte formant conduit d'air de sorte que la dérivation communique avec les conduits d'air de refroidissement des semi-conducteurs des modules restants (6) de ladite pile, les cellules centrales desdits modules restants étant fermées.

2. Appareil de refroidissement à écoulement en série-parallèle selon la revendication 1, caractérisé en ce que lesdites cellules centrales ouvertes (7e) formant conduit d'air comprennent une ouverture (7d) qui est ménagée dans un capot fermé (7b), dans la partie centrale dudit module (6).

3. Appareil de refroidissement à écoulement en série-parallèle selon la revendication 1 ou 2, caractérisé en ce que le premier de module au bas de ladite pile comporte une plaque d'étranglement (16) ayant une ouverture dont la forme correspond à celle de l'ouverture desdites cellules centrales ouvertes (7e) formant conduit d'air, afin de définir un écoulement de gaz approprié.

0 099 092

FIG. 1

FIG. 2

FIG. 3

1

# 0 099 092

FIG. 4

2

FIG. 5

FIG. 6

FIG. 7

FIG. 8

FIG. 9

FIG.10

FIG.12

4

FIG.11